# EUROPEAN PATENT APPLICATION

(11) **EP 3 617 818 A1**
(43) Date of publication of application: **04.03.2020**
(21) Application number: 19192357.2
(22) Date of filing: 19.08.2019
(51) Int. Cl.: G05B 17/02, G05B 23/02, G06F 11/00

(54) **METHOD AND SYSTEM FOR PREDICTING SEMICONDUCTOR FATIGUE**

(30) Priority: 21.08.2018 US 201816106149
(71) Applicant: GE Aviation Systems LLC, Grand Rapids, MI 49512 (US)
(72) Inventor: THERIAULT, Timothy, Grand Rapids, Michigan 49512 (US)
(74) Representative: Openshaw & Co.

(57) **Abstract**

A method and system for predicting determining semiconductor (72) fatigue can include receiving, at a controller module (74), a set of performance characteristics from a semiconductor (72) over a period of time, generating, by the controller module (74), a semiconductor performance profile from the set of performance characteristics, and scheduling maintenance (88) related to the semiconductor (72) based on the predicted end of useful life of the semiconductor (72).

## Description

### TECHNICAL FIELD

The disclosure relates to a method and system for determining, estimating, or predicting fatigue or failure of a semiconductor device.

### BACKGROUND

Printed circuit boards (PCBs) or integrated circuits can support and interconnect set of electrical components such as capacitors, resistors, and semiconductors, such as processors solid-state switches, and the like. Operation of the semiconductors introduce fatigue to the semiconductors over a period of time, and can result in failure or unexpected operation of the semiconductors or PCBs.

### BRIEF DESCRIPTION

In one aspect, the present disclosure relates to a method of determining semiconductor fatigue, including receiving, at a controller module, a set of performance characteristics from a semiconductor over a period of time, the set of performance characteristics including at least a semiconductor temperature, generating, by the controller module, a semiconductor performance profile from the set of performance characteristics, comparing, by the controller module, the semiconductor performance profile with a fatigue model, predicting, by the controller module, an end of useful life of the semiconductor based on the comparison of the semiconductor profile with the fatigue model, and scheduling maintenance related to the semiconductor based on the predicted end of useful life of the semiconductor.

In another aspect, the present disclosure relates to a system for predicting fatigue of a semiconductor, including a temperature sensor associated with the semiconductor configured to provide an operational temperature of the semiconductor over a period of time, memory storing a semiconductor fatigue model and component data related to the semiconductor, including at least a minimum feature size dimension of the semiconductor, and a controller module configured to receive the temperature of the semiconductor over the period of time, to generate a semiconductor performance profile, to compare the semiconductor performance profile with the semiconductor fatigue model, to predict and end of useful life of the semiconductor based on the comparison of the semiconductor profile with the fatigue model, and to schedule maintenance related to the semiconductor based on the predicted end of useful life of the semiconductor.

In yet another aspect, the present disclosure relates to a method of estimating semiconductor fatigue, the method including predicting a set of performance characteristics over a period of time based on a predetermined installation location of a semiconductor, the set of performance characteristics including at least a predicted semiconductor temperature based on the installation location of the semiconductor, receiving, at a controller module, the set of predicted performance characteristics from the semiconductor, generating, by the controller module, a semiconductor performance profile from the set of predicted performance characteristics, comparing, by the controller module, the semiconductor performance profile with a fatigue model, estimating, by the controller module, an end of useful life of the semiconductor based on the comparison of the semiconductor profile with the fatigue model, and scheduling maintenance related to the semiconductor based on the estimated end of useful life of the semiconductor.

### BRIEF DESCRIPTION OF THE DRAWINGS

In the drawings:
FIG. 1 illustrates a schematic view of semiconductor of a printed circuit board (PCB).
FIG. 2 illustrates a chart demonstrating useful life of a semiconductor, such as the semiconductor of FIG. 1, in accordance with various aspects described herein.
FIG. 3 illustrates a system for estimating semiconductor fatigue, in accordance with various aspects described herein.
FIG. 4 illustrates a flow chart demonstrating a method of predicting semiconductor fatigue using the system of FIG. 3, in accordance with various aspects described herein.
FIG. 5 is a flow chart demonstrating another method of predicting semiconductor fatigue, in accordance with various aspects described herein.
FIG. 6 is a flow chart demonstrating yet another method of estimating semiconductor fatigue, in accordance with various aspects described herein.

### DETAILED DESCRIPTION

Aspects of the disclosure can be implemented in any environment, apparatus, or method wherein a semiconductor, including but not limited to, a processor, a transistor, a solid state switch, or the like, is included, disposed, or otherwise located as a component in a system. In one non-limiting example, the system could include a set of semiconductors, printed circuit boards (PCBs), integrated circuits, or the like. In another non-limiting example, the semiconductor can be located, positioned, or the like on a vehicle, such as an air-based vehicle (e.g. an aircraft), a land based vehicle, or an aqueous-based vehicle.

One non-limiting example of a semiconductor can include a silicon carbide (SiC) or Gallium Nitride (GaN) based, high power switch. SiC or GaN can be selected based on their solid state material construction, their ability to handle high voltages and large power levels in smaller and lighter form factors, and their high speed switching ability to perform electrical operations very quickly. Additional switching devices or additional silicon-based power switches can be included.

While "a set of' various elements will be described, it will be understood that "a set" can include any number of the respective elements, including only one element. Connection references (e.g., attached, coupled, connected, and joined) are to be construed broadly and can include intermediate members between a collection of elements and relative movement between elements unless otherwise indicated. As such, connection references do not necessarily infer that two elements are directly connected and in fixed relation to each other. In non-limiting examples, connections or disconnections can be selectively configured to provide, enable, disable, or the like, an electrical connection between respective elements.

Also as used herein, while sensors can be described as "sensing" or "measuring" a respective value, sensing or measuring can include determining a value indicative of or related to the respective value, rather than directly sensing or measuring the value itself. The sensed or measured values can further be provided to additional components. For instance, the value can be provided to a controller module or processor, and the controller module or processor can perform processing on the value to determine a representative value or an electrical characteristic representative of said value.

As used herein, a "system" or a "controller module" can include at least one processor and memory. Non-limiting examples of the memory can include Random Access Memory (RAM), Read-Only Memory (ROM), flash memory, or one or more different types of portable electronic memory, such as discs, DVDs, CD-ROMs, etc., or any suitable combination of these types of memory. The processor can be configured to run any suitable programs or executable instructions designed to carry out various methods, functionality, processing tasks, calculations, or the like, to enable or achieve the technical operations or operations described herein. The program can include a computer program product that can include machine-readable media for carrying or having machine-executable instructions or data structures stored thereon. Such machine-readable media can be any available media, which can be accessed by a general purpose or special purpose computer or other machine with a processor. Generally, such a computer program can include routines, programs, objects, components, data structures, algorithms, etc., that have the technical effect of performing particular tasks or implement particular abstract data types.

All directional references (e.g., radial, axial, upper, lower, upward, downward, left, right, lateral, front, back, top, bottom, above, below, vertical, horizontal, clockwise, counterclockwise) are only used for identification purposes to aid the reader's understanding of the disclosure, and do not create limitations, particularly as to the position, orientation, or use thereof. As used herein the term "determining" refers to a determination of the system or method of an outcome or result that has occurred or is occurring (e.g. a "current" or "present" outcome or result), and contrasts with the term "estimated," which refers to a forward-looking determination or estimation that makes the outcome or result known in advance of actual performance of the occurrence. For instance, in the context of the current disclosure, a semiconductor that has operated in an installed environment can have a "determined" fatigue threshold, in contrast with a semiconductor that has not yet been designed or installed in an environment, which can have an "estimated" fatigue threshold.

The exemplary drawings are for purposes of illustration only and the dimensions, positions, order and relative sizes reflected in the drawings attached hereto can vary.

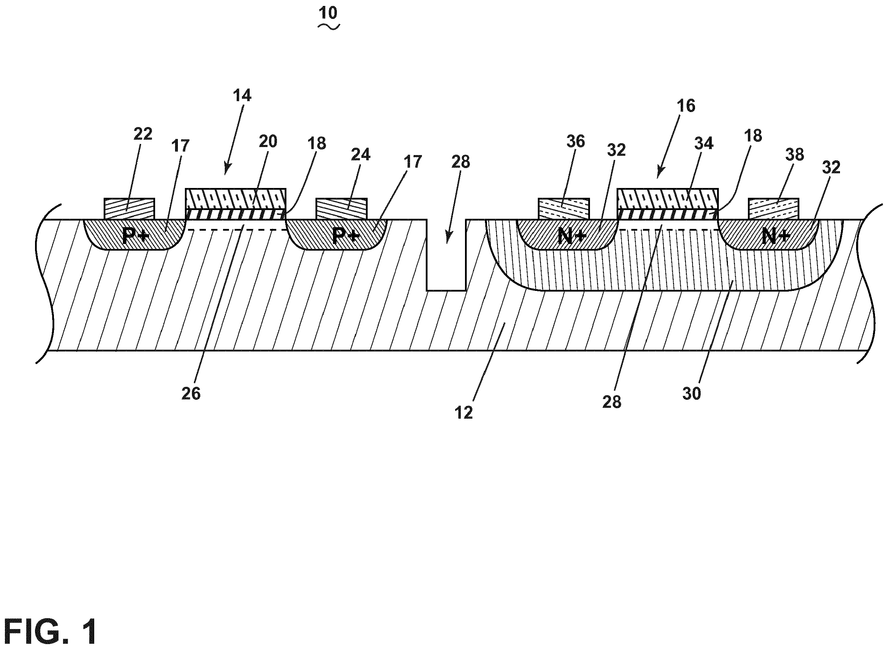

FIG. 1 illustrates an example semiconductor 10, for ease of understanding aspects of the disclosure. The semiconductor 10 is shown having a substrate 12 and including a first transistor 14 spaced from a second transistor 16 by an isolation trench 28. In one non-limiting example, each of the first and second transistors 14, 16 can include complementary metal-oxide-semiconductor (CMOS) transistors. In one example, the first transistor 14 can include an n-type substrate 12 having spaced "p+" taps 17 electrically connected with a respective source connector 22 and drain connector 24. The first transistor 14 further includes an gate oxide layer 18 positioned on a surface of the substrate 12 of the semiconductor 10 laterally between the respective p+ taps 17, as well as a gate connector 20 overlying the gate oxide layer 18.

In another example, the second transistor 16 can include a p-well 30 received into the n-type substrate 12 underlying the second transistor 16, further including spaced "n+" taps 32. The n+ taps 32 are respectively connected with a second source connector 36 and a second drain connector 38. The second transistor 16 further includes the gate oxide layer 18 positioned on the surface of the p-well 30 laterally between the respective n+ taps 32 and a gate connector 34 overlying the gate oxide layer 18.

During the operation of the first transistor 14, a voltage applied to the gate connector 20 can create a conducting channel (schematically represented by dotted channel 26) in the substrate 12 to enable conduction of current from the source connector 22 to the drain connector 24. Similarly, during operation of the second transistor 16, a voltage applied to the gate connector 34 can create a conducting channel (schematically represented by dotted channel 28) in the p-well 30 to enable conduction of current from the source connector 36 to the drain connector 38.

Operation of semiconductors 10, such as the first or second transistor 14, 16, over a period of time can result in "wearing out" effects or "fatigue" effects that reduce their useful life of operation. As used herein, a "useful life" of a semiconductor 10 includes an expected, predicted, estimated period of operational time of the semiconductor 10, wherein the semiconductor 10 operates with predictable operational characteristics. In one non-limiting example, the "useful life" of a semiconductor 10 can be defined by operational characteristic thresholds, including but not limited to, voltage thresholds or conductive thresholds. In one non-limiting example, the "useful life" of a semiconductor 10 can cease or end when the semiconductor experiences failure, or otherwise ceases to perform as expected. In another non-limiting example, the "useful life" of a semiconductor 10 can cease or end prior to the expected or predicted failure of the semiconductor 10.

One example fatigue effect of the semiconductor 10 can include electromigration fatigue, whereby the gradual movement of the ions in a semiconductor 10 result in the physical movement of interconnect metallization material of the semiconductor 10. For instance, the physical movement of atoms of the semiconductor 10 material can reduce or separate terminals, junctions, or the like, resulting in the failure or reduced operation of the semiconductor 10.

Another example fatigue effect of the semiconductor 10 can include time-dependent dielectric breakdown, wherein the dielectric is the gate oxide layer 18. In this fatigue effect, the gate oxide layer 18 can break down as a result of extended applications of a relatively low electric field applied by a voltage at the gate conductor 20, 34. The breakdown is caused by formation of a conductive path through the gate oxide layer 18 to the substrate 12 (or p-well 30) due to electron tunneling current. The breakdown can depend on, for example, a thickness of the dielectric gate oxide layer 18 or material type.

A third example fatigue effect of the semiconductor 10 can include hot carrier injection effects, whereby an electron (or conversely, a "hole") of the semiconductor 10 gains a sufficient amount of kinetic energy to overcome the potential barrier of the substrate 12 (or p-well 30) between respective taps 17, 32, and becomes "injected" from the conducting channel 26, 28 to the gate oxide layer 18, becoming trapped. The hot carrier injection effects can permanently change the switching characteristics of the transistor 14, 16. It is noted the term "hot" in hot carrier injection refers to the temperature used to model carrier density, not an overall temperature of the semiconductor 10 or transistor 14, 16.

A fourth example fatigue effect of the semiconductor 10 can include bias temperature instability, affecting a change in the threshold voltage (e.g. the minimum gate-to-source voltage difference that is needed to create a conducting path between the source and drain terminals), and resulting is a divergence of drain current compared with expected transistor 14, 16 operational conditions.

In one non-limiting example, at least a subset of the above-mentioned fatigue effects can affected by the operational characteristics of the semiconductor 10. For instance, the operating environment or location of the semiconductor 10 can increase (or accelerate) or reduce (or slow) at least a subset of the fatigue effects. In another instance, the temperature of the operating environment or location of the semiconductor 10 can increase or reduce at least a subset of the fatigue effects. In another instance, the operating voltage, current, or duty cycle of the semiconductor 10 can increase or reduce at least a subset of the fatigue effects. In yet another instance, the minimum feature size dimension of the semiconductor 10 can increase or reduce at least a subset of the fatigue effects. As used herein, the minimum feature size dimension of the semiconductor 10 refers to the size or the width at which a transistor 14, 16 or any type of material on the substrate 12 surface can be drawn at. In one example, the minimum feature size dimension is measured in nanometers.

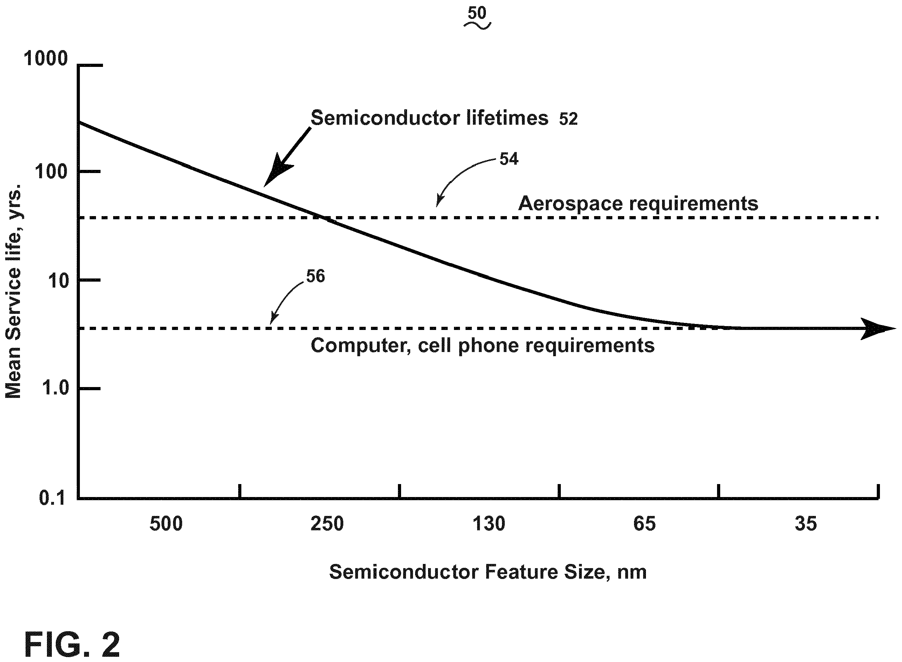

Additionally, the effective wearing out effects or fatigue effects described herein can be further impacted by the expected service life or requirements of the implementations. For example, FIG. 2 illustrates an example chart 50 demonstrating useful life of a semiconductor 10, in accordance with various aspects described herein. Generally, as the minimum feature size dimension is reduced, the useful life 52 of the semiconductor 10 (e.g. shown as the mean service life in years) is reduced. FIG. 2 further illustrates example threshold requirements of the useful life 52 which can be further limiting, based on the standards or a particular industry or governing body. For example, aerospace requirements can define a first useful life threshold 54 based on industry expectations or governing rules, while computer or cell phone requirements can define a second useful life threshold 56 based on industry expectations or governing rules. As shown, the first useful threshold 54 has higher, or stricter requirements than the second useful threshold 56.

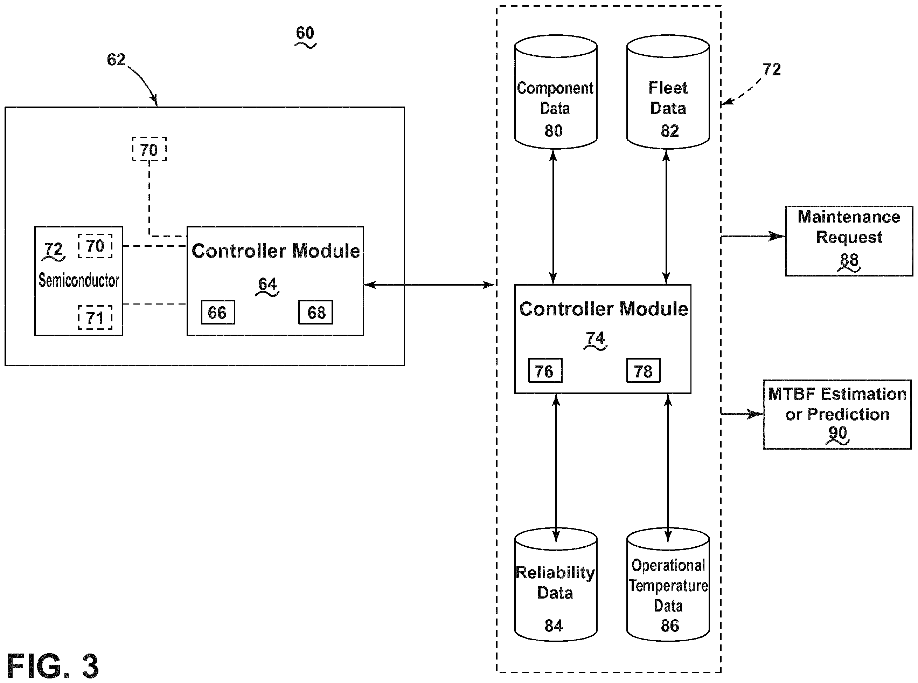

FIG. 3 illustrates a system 60 for predicting fatigue of a semiconductor. The system 60 can include installation 62 having a semiconductor 72. As used herein, an "installation" 62 can include any location storing, containing, or otherwise including the semiconductor 72. Non-limiting examples of installations 62 can include PCBs, housings, chassis, server housings, computer bays, aircraft, vehicles, or the like. Generally, the installation 62, or portions thereof, can define environmental characteristics, as described herein. The semiconductor 72 can include aspects of the semiconductor 10 of FIG. 1, but is not limited to the aspects of the semiconductor 10.

The installation 62 can further include a first controller module 64, shown having a processor 66 and memory 68. The installation 62 can further include sensors, shown as a temperature sensor 70, configured to sense, measure, or otherwise provide an operational temperature of the installation 62 over a period of time. Alternative, or in addition, the semiconductor 72 can include a temperature sensor 70 configured to sense, measure, or otherwise provide an operational temperature of the semiconductor 72 over a period of time. In this sense, one or more temperature sensors 70 can be associated with the semiconductor 72 to sense, measure, or otherwise provide an operational temperature of the semiconductor 72, or the operational temperature the semiconductor 72 is exposed to, over a period of time. In further non-limiting examples, the semiconductor 72 can optionally include one or more additional sensors, shown schematically as a second sensor 71, configured to sense additional semiconductor 72 characteristics. For example, the second sensor 71 can sense or measure the operating voltage, current, or duty cycle of the semiconductor 10 over a period of time.

The temperature sensor(s) 70 and the optional second sensor 71 can communicatively provide the respective sensed or measured characteristics (collectively, "the performance characteristics of the semiconductor 72") to the first controller module 64, or to the memory 68 thereof, for storage over a period of time. Example periods of time can include minutes, hours, days, weeks, months, or cycle-oriented periods of time, such as flights, maintenance cycles, data dump periods, or the like.

The system 60 can further include prediction module 72, schematically shown in dotted outline. The prediction module 72 can include a second controller module 74 having a processor 76 and memory 78, and be communicatively connected with component data 80, fleet data 82, reliability data 84, and operational temperature data 86. Non-limiting examples of component data 80 can include data or performance characteristics associated with the semiconductor 72, or particular models of the semiconductor 72, including, but not limited to, expected service life, service requirements, service life requirements (e.g. thresholds 54, 56), minimum feature size dimensions for the semiconductor 72, or the like.

Reliability data 84 can store data related to the reliability of the semiconductor 72 over a period of operational time. In this sense, the reliability data 84 can include, but is not limited to, a set of fatigue models or fatigue modeling, including but not limited to, electromigration fatigue, time-dependent dielectric breakdown, hot carrier injection effects, or bias temperature instability, or a combination thereof. Operational temperature data 86 can include data related to the estimated or predicted operational temperature of one or more particular locations, such as the installation 62 or a subportion thereof. For example, an installation 62 of the semiconductor 72 in an aircraft engine will have a higher continuous expected operational temperature, compared with an installation 62 of a semiconductor 72 within an electronics bay of an aircraft. The fleet data 82 can include historical or current data related to a number of semiconductors 72 or installations 62 across multiple installations 62. For example, the fleet data 82 can include historical or current data related to installations 62 of semiconductors 72 within a single aircraft (e.g. a first installation 62 at the aircraft engine and a second installation 62 at an electronics bay), or across any number of installations 62 (e.g. a set of installations 62 across a fleet of aircraft).

The first controller module 64 or memory 68 of the installation 62 can be adapted or configured to communicate with the prediction module 72 on a continuous or intermittent basis. For example, in non-limiting examples, the prediction module 72 can receive or download performance data of the semiconductor 72 once a week, in between aircraft flights, or during maintenance operations. While only a single installation 62 is shown, aspects of the disclosure can be included wherein the prediction module 72 can continuously or intermittently receive a set of semiconductor 72 performance data from a first controller module 64 or memory 68 of a set of installations 62. Any number of permutations between semiconductors 72, installations, first controller modules 64, or memory 68 can be include in aspects of the disclosure.

The prediction module 72 can operate to predict semiconductor 72 fatigue based on aspects described herein. For example, in response to receiving the performance characteristics of the semiconductor 72, the second controller module 74 or processor 76 can generate a semiconductor 72 performance profile. The semiconductor 72 performance profile can include temperature data over a period of time, voltage, current, or duty cycle data over a period of time, or other information. In one non-limiting example, the semiconductor 72 performance profile can include histograms or other representative information described herein.

The prediction module 72 can further compare the semiconductor 72 performance profile with the reliability data 84, such as the fatigue models, in order to identify trends, indicators, alerts, or any other instances representative of semiconductor 72 fatigue described herein. In another non-limiting example, the comparison can compare the semiconductor 72 performance profile with expected service life requirements (e.g. threshold 54, 56) stored in the component data 80.

In yet another non-limiting example, the reliability data 84 can include any number of fatigue models adapted for different component data 80 associated with the semiconductor 72 performance profile. For example, a first set of fatigue models can be selected from a larger set of fatigue model, wherein the first set of fatigue models are calibrated, associated with, or otherwise related to at least one of the minimum feature size dimension of the semiconductor 72, the installation 62 location or position, or a combination thereof. In this sense, the prediction module 72 can identify trends, indicators, alerts, or any other instances representative of semiconductor 72 fatigue for a particular semiconductor minimum feature size dimension, a particular installation 62 location, or a combination thereof.

In response to the comparison of the semiconductor 72 performance profile with the reliability data 84, the prediction module 72 can, for example, determine that maintenance is required when the comparison satisfies a comparison threshold (e.g. the comparison indicates impaired semiconductor 72 performance due to semiconductor 72 fatigue). For example, the prediction module 72 can generate a maintenance record, such as a maintenance request 88. As used herein, a maintenance request 88 can include actual, estimated, or predicted services to be completed. For example, a maintenance request 88 can be urgent (e.g. remove the aircraft from active service), or can be passive (e.g. the next time the aircraft is out of service, perform the maintenance request 88), in this sense, the maintenance request 88 can include the actual performance of the maintenance. As used herein, the term "satisfies" the comparison, threshold value, or range means that the operation of the semiconductor 72 satisfies one or more predetermined thresholds for fatigue models, such as being equal to or less than a threshold value, or being within the threshold value range. It will be understood that such a determination may easily be altered to be satisfied by a positive/negative comparison or a true/false comparison.

In another non-limiting aspect of the disclosure, the comparison of the semiconductor 72 performance profile with the reliability data 84can, for example, determine that comparison does not satisfy a comparison threshold (e.g. the comparison indicates the semiconductor 72 performance profile is within expected operational limits. If the semiconductor 72 performance profile is determined to be within expected operational limits, the prediction module 72 can further be configured to generate an estimated or predicted useful life going forward for the semiconductor 72, for example, based on determining where in the existing useful life the semiconductor 72 is currently. In another non-limiting example, the estimated or predicted useful life going forward can include or incorporated expected fatigue of the semiconductor 72 based on, for example, the fatigue models, the continued placement or locating of the semiconductor 72 in the location of the installation 62, the operational data 86 associated with that particular placement, and other historical or predictive data accessible by the second controller module 74. The estimated or predicted useful life going forward can be schematically represented by the mean time between failure (MTBF) estimation or prediction 90. In another non-limiting example, the prediction module 72 can generate a maintenance request 88 based on the remaining useful life prediction of the semiconductor 72, such that the semiconductor 72 is serviced prior to the expiration of the remaining predicted useful life.

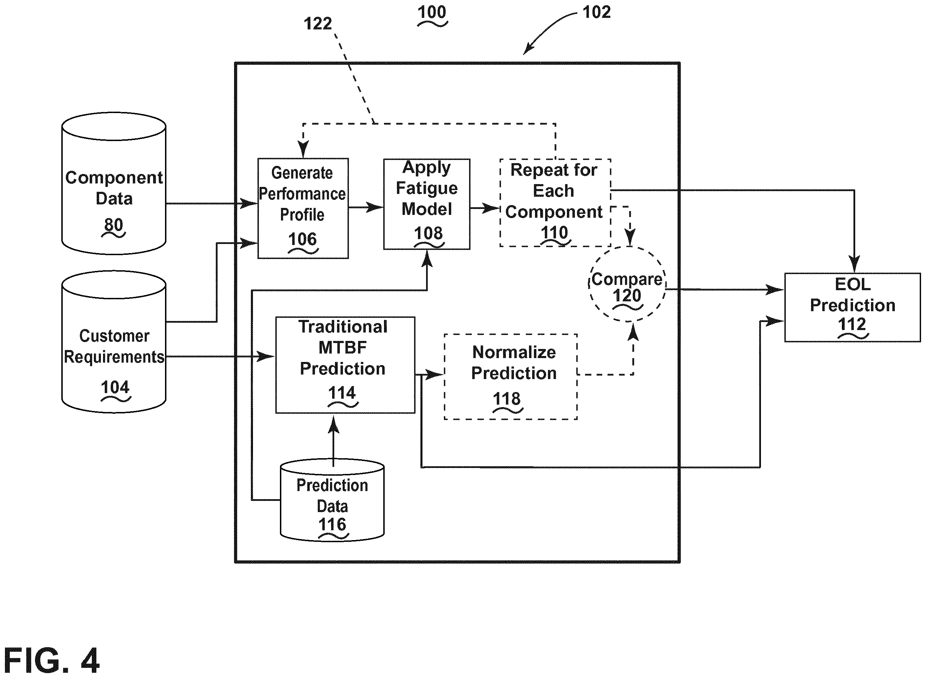

FIG. 4 illustrates a flow chart 100 of a system 102 for estimating semiconductor fatigue, in accordance with additional aspects of the disclosure. A shown, the system 102 can include first generating a semiconductor performance profile at 106 in response to receiving designated component data 80 and customer requirements 104 for the semiconductor. The generated semiconductor performance profile can then have a set or subset of the aforementioned fatigue models applied to the semiconductor performance profile at 108 to generate the estimated fatigue or estimated useful life of the semiconductor. In one non-limiting example, the set or subset of fatigue models can be received from prediction data 116. In another non-limiting example, the prediction data 116 can further include and provide models related to the expected, desired, or predicted installation environment, for instance, as defined by the component data 80, the customer requirements 104, or a combination thereof.

If only a single semiconductor useful life is being estimated, the useful life estimation can be provided as an output at 112 (end of life or "EOL" prediction). If a set of semiconductor useful lives are being estimated (for example, a set of semiconductors in an integrated circuit), the aforementioned process can be repeated for each of the semiconductor components at 110, with return arrow 122 returning to steps 106 and 108. Upon completing the estimated useful life of the last semiconductor component, the earliest estimated or predicted end of useful life of the set of semiconductors can be selected. The estimated useful life of the semiconductor can be further included in developing, scheduling, or performing maintenance actions, as described herein.

FIG. 4 further illustrates that a traditional or conventional MTBF prediction can be generated by the system 102 at 114, by receiving the customer requirements 104 and the prediction data 116. The traditional MTBF prediction can optionally be normalized at 118. The traditional MTBF from step 114 or the normalized MTBF prediction from step 118 can optionally be compared in step 120, and can further be provided as the EOL prediction 112 for further comparison. In yet another non-limiting exampling, the traditional MTBF prediction can also be provided to the EOL prediction 112 for comparison.

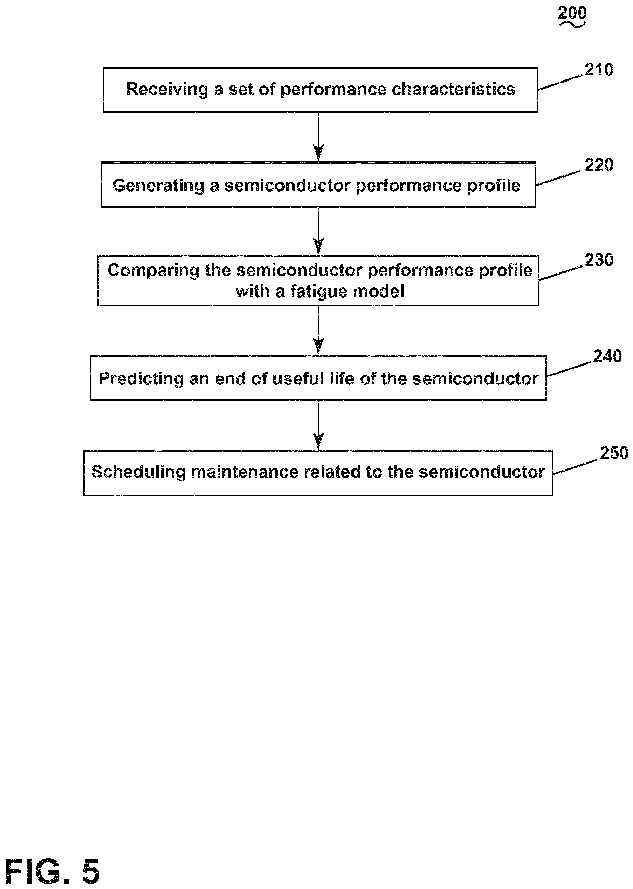

FIG. 5 illustrates a flow chart demonstrating a method 300 of determining semiconductor 72 fatigue. The method 200 begins by receiving, at a controller module 74, a set of performance characteristics from a semiconductor 72 over a period of time, the set of performance characteristics including at least a semiconductor temperature, for example, as sensed by temperature sensors 70, at 210. Next, the method 200 proceeds to generate, by the controller module 74, a semiconductor 72 performance profile from the set of performance characteristics, at 220. The method 200 continues to compare, by the controller module 74, the semiconductor 72 performance profile with a fatigue model, at 230. Based on the comparison, the method 200 then predicts, by the controller module 74, an end of useful life of the semiconductor 72, at 240. Finally, the method 200 concludes by scheduling maintenance related to the semiconductor 72 based on the predicted end of useful life of the semiconductor 72, at 250.

The sequence depicted is for illustrative purposes only and is not meant to limit the method 200 in any way as it is understood that the portions of the method 200 can proceed in a different logical order, additional or intervening portions can be included, or described portions of the method can be divided into multiple portions, or described portions of the method can be omitted without detracting from the described method.

For example, in one example the method 200 can further include receiving, at the controller module 74, a set of semiconductor 72 information, including at least a minimum feature size dimension. In another non-limiting example the method 200 can include selecting the fatigue model from a set of fatigue models based on at least a subset of the semiconductor 72 information, such as selected based on at least the minimum feature size dimension, the installation 62 position, or both. In another non-limiting example, the fatigue model can include data related to at least a subset of: electromigration fatigue, time-dependent dielectric breakdown, hot carrier injection effects, or bias temperature instability, or a combination thereof. In yet another non-limiting example, the method 200 can further include repeating the receiving at 210, the generating at 220, the comparing at 230, and the predicting at 240 for each semiconductor 72 in a set of semiconductors 72 of an integrated circuit, selecting the earliest predicted end of useful life of the set of semiconductors 72, and scheduling maintenance related to the integrated circuit based on the earliest predicted end of useful life of the set of semiconductors 72.

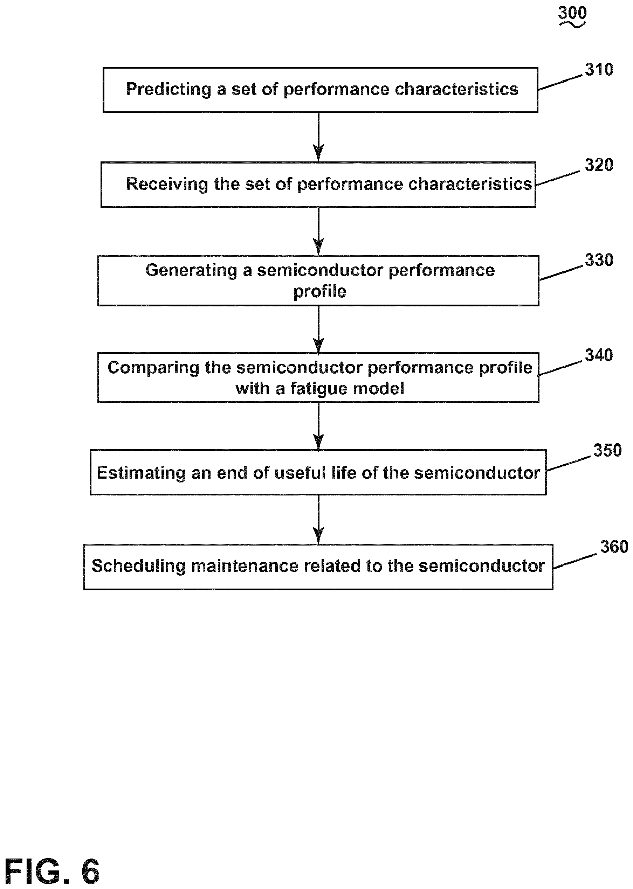

FIG. 6 illustrates a flow chart demonstrating a method 300 of estimating semiconductor 72 fatigue. The method 300 begins by predicting a set of performance characteristics over a period of time based on a predetermined installation 65 location of a semiconductor 72, the set of performance characteristics including at least a predicted semiconductor 72 temperature based on the installation 62 location of the semiconductor 72, at 310. The method 300 can further include receiving, at a controller module 74, the set of predicted performance characteristics from the semiconductor 72, at 320. Next the method 300 can proceed to generating, by the controller module 74, a semiconductor 72 performance profile from the set of predicted performance characteristics, at 330.

Next, the method 300 can continue to comparing, by the controller module 74, the semiconductor 72 performance profile with a fatigue model, at 340, followed by estimating, by the controller module74, an end of useful life of the semiconductor 72 based on the comparison of the semiconductor 72 profile with the fatigue model, at 350. Finally, the method 300 concludes by scheduling maintenance related to the semiconductor 72 based on the estimated end of useful life of the semiconductor 72, at 360.

Many other possible aspects and configurations in addition to that shown in the above figures are contemplated by the present disclosure.

The aspects disclosed herein provide a system and method for determining, predicting, or estimating semiconductor fatigue. The technical effect of aspects of the disclosure can include determined, predicting, or estimating a useful life or lifespan for a semiconductor device by comparing the performance profile of the semiconductor against fatigue models. As semiconductor devices shrink below 90 nm feature sizes they become increasing sensitive to intrinsic wear out mechanism such as electromigration fatigue, time-dependent dielectric breakdown, hot carrier injection effects, or bias temperature instability that reduce their useful life to a point that these may compete with traditional electronic failure modes. Furthermore these fatigue effects can be accelerated by temperature of the semiconductor or installation location temperature of the semiconductor. Thus, the semiconductor performance profile including aspect of feature sizes, temperatures over a period of time, or a combination thereof can be used to determine, predict, or estimate wear out life expectancy with a better approximation to real fatigue effects compared with conventional estimations. This information can then be used to alert system maintainers of necessary repair and maintenance actions or it can be used to activate redundant functions at the appropriate time to ensure that maximum in service availability and system level reliability are achieved. Improved service available and system level reliability can be achieved on a semiconductor-by semiconductor, integrated circuit-by-integrated circuit, or larger system-by-system (e.g. aircraft-by-aircraft) basis.

To the extent not already described, the different features and structures of the various aspects can be used in combination with each other as desired. That one feature cannot be illustrated in all of the aspects is not meant to be construed that it cannot be, but is done for brevity of description. Thus, the various features of the different aspects can be mixed and matched as desired to form new aspects, whether or not the new aspects are expressly described. Combinations or permutations of features described herein are covered by this disclosure.

Further aspects of the invention are provided by the subject matter of the following clauses:
1. A method of determining semiconductor fatigue, comprising receiving, at a controller module, a set of performance characteristics from a semiconductor over a period of time, the set of performance characteristics including at least a semiconductor temperature, generating, by the controller module, a semiconductor performance profile from the set of performance characteristics, comparing, by the controller module, the semiconductor performance profile with a fatigue model, predicting, by the controller module, an end of useful life of the semiconductor based on the comparison of the semiconductor profile with the fatigue model, and scheduling maintenance related to the semiconductor based on the predicted end of useful life of the semiconductor.
2. The method of any preceding clause, further comprising receiving, at the controller module, a set of semiconductor information, including at least a minimum feature size dimension.
3. The method of any preceding clause wherein the fatigue model is selected from a set of fatigue models based on at least a subset of the semiconductor information.
4. The method of any preceding clause wherein the fatigue model is selected based at least the minimum feature size dimension.
5. The method of any preceding clause, further comprising receiving, at the controller module, a set of semiconductor information further including a semiconductor installation position.
6. The method of any preceding clause, wherein the fatigue model is selected from a set of fatigue models based on the semiconductor installation position.
7. The method of any preceding clause wherein the fatigue model includes data related to at least a subset of: electromigration fatigue, time-dependent dielectric breakdown, hot carrier injection effects, or bias temperature instability.
8. The method of any preceding clause wherein the fatigue model includes data related to each of: electromigration fatigue, time-dependent dielectric breakdown, hot carrier injection effects, and bias temperature instability.
9. The method of any preceding clause, further comprising repeating the receiving, the generating, the comparing, and the predicting for each semiconductor in a set of semiconductors of an integrated circuit, selecting the earliest predicted end of useful life of the set of semiconductors, and scheduling maintenance related to the integrated circuit based on the earliest predicted end of useful life of the set of semiconductors.
10. A system for predicting fatigue of a semiconductor, comprising a temperature sensor associated with the semiconductor configured to provide an operational temperature of the semiconductor over a period of time, memory storing a semiconductor fatigue model and component data related to the semiconductor, including at least a minimum feature size dimension of the semiconductor, and a controller module configured to receive the temperature of the semiconductor over the period of time, to generate a semiconductor performance profile, to compare the semiconductor performance profile with the semiconductor fatigue model, to predict and end of useful life of the semiconductor based on the comparison of the semiconductor profile with the fatigue model, and to schedule maintenance related to the semiconductor based on the predicted end of useful life of the semiconductor.
11. The system of any preceding clause wherein the memory further stores a set of semiconductor fatigue models, and wherein the controller module is further configured to select the semiconductor fatigue model from the set of semiconductor fatigue models based on at least the component data related to the semiconductor.
12. The system of any preceding clause wherein the controller module is configured to select the semiconductor fatigue model from the set of semiconductor fatigue models further based on at least the minimum feature size dimension of the semiconductor and an installation position of the semiconductor.
13. The system of any preceding clause wherein the fatigue model includes data related to at least a subset of: electromigration fatigue, time-dependent dielectric breakdown, hot carrier injection effects, or bias temperature instability.
14. The system of any preceding clause wherein the fatigue model includes data related to each of: electromigration fatigue, time-dependent dielectric breakdown, hot carrier injection effects, and bias temperature instability.
15. The system of any preceding clause wherein the controller module is further configured to repeat the receiving, the generating, the comparing, and the predicting for each semiconductor in a set of semiconductors of an integrated circuit, and to select the earliest predicted end of useful life of the set of semiconductors, and the scheduling maintenance related to the integrated circuit is based on the earliest predicted end of useful life of the set of semiconductors.
16. A method of estimating semiconductor fatigue, the method comprising predicting a set of performance characteristics over a period of time based on a predetermined installation location of a semiconductor, the set of performance characteristics including at least a predicted semiconductor temperature based on the installation location of the semiconductor, receiving, at a controller module, the set of predicted performance characteristics from the semiconductor, generating, by the controller module, a semiconductor performance profile from the set of predicted performance characteristics, comparing, by the controller module, the semiconductor performance profile with a fatigue model, estimating, by the controller module, an end of useful life of the semiconductor based on the comparison of the semiconductor profile with the fatigue model, and scheduling maintenance related to the semiconductor based on the estimated end of useful life of the semiconductor.
17. The method of any preceding clause wherein the set of performance characteristics includes at least a minimum feature size dimension of the semiconductor.
18. The method of any preceding clause wherein the fatigue model is selected from a set of fatigue models based on at least the minimum feature size dimension of the semiconductor and the predetermined installation location of the semiconductor.
19. The method of any preceding clause wherein the fatigue model includes data related to at least a subset of: electromigration fatigue, time-dependent dielectric breakdown, hot carrier injection effects, or bias temperature instability.
20. The method of any preceding clause, further comprising repeating the predicting, the receiving, the generating, the comparing, and the estimating for each semiconductor in a set of semiconductors of an integrated circuit, selecting the earliest estimated end of useful life of the set of semiconductors, and scheduling maintenance related to the integrated circuit based on the earliest estimated end of useful life of the set of semiconductors.

This written description uses examples to disclose aspects of the disclosure, including the best mode, and also to enable any person skilled in the art to practice aspects of the disclosure, including making and using any devices or systems and performing any incorporated methods. The patentable scope of the disclosure is defined by the claims, and can include other examples that occur to those skilled in the art. Such other examples are intended to be within the scope of the claims if they have structural elements that do not differ from the literal language of the claims, or if they include equivalent structural elements with insubstantial differences from the literal languages of the claims.

## Claims

1. A method of determining semiconductor (72) fatigue, comprising:
receiving, at a controller module (74), a set of performance characteristics from a semiconductor (72) over a period of time, the set of performance characteristics including at least a semiconductor (72) temperature;
generating, by the controller module (74), a semiconductor (72) performance profile from the set of performance characteristics;
comparing, by the controller module (74), the semiconductor (72) performance profile with a fatigue model;
predicting, by the controller module (74), an end of useful life of the semiconductor (72) based on the comparison of the semiconductor (72) profile with the fatigue model; and
scheduling maintenance related to the semiconductor (72) based on the predicted end of useful life of the semiconductor (72).

2. The method of claim 1, further comprising receiving, at the controller module (74), a set of semiconductor (72) information, including at least a minimum feature size dimension.

3. The method of claim 2 wherein the fatigue model is selected from a set of fatigue models based on at least a subset of the semiconductor (72) information.

4. The method of claim 3 wherein the fatigue model is selected based on at least the minimum feature size dimension.

5. The method of any of claims 1 to 4, further comprising receiving, at the controller module, a set of semiconductor (72) information including a semiconductor (72) installation position.

6. The method of any of claims 1 to 5, wherein the fatigue model includes data related to at least a subset of: electromigration fatigue, time-dependent dielectric breakdown, hot carrier injection effects, or bias temperature instability.

7. The method of any of claims 1 to 6, wherein the fatigue model includes data related to each of: electromigration fatigue, time-dependent dielectric breakdown, hot carrier injection effects, and bias temperature instability.

8. The method of any of claims 1 to 7, further comprising repeating the receiving, the generating, the comparing, and the predicting for each semiconductor (72) in a set of semiconductors (72) of an integrated circuit, selecting the earliest predicted end of useful life of the set of semiconductors (72), and scheduling maintenance related to the integrated circuit based on the earliest predicted end of useful life of the set of semiconductors (72).

9. A system for predicting fatigue of a semiconductor (72), comprising:
a temperature sensor (70) associated with the semiconductor (72) configured to provide the operational temperature of the semiconductor (72) over a period of time;
memory (78) storing a semiconductor (72) fatigue model and component data (80) related to the semiconductor (72), including at least a minimum feature size dimension of the semiconductor (72); and
a controller module (74) configured to receive the temperature of the semiconductor (72) over the period of time, to generate a semiconductor (72) performance profile, to compare the semiconductor (72) performance profile with the semiconductor (72) fatigue model, to predict and end of useful life of the semiconductor (72) based on the comparison of the semiconductor (72) profile with the fatigue model, and to schedule maintenance related to the semiconductor (72) based on the predicted end of useful life of the semiconductor (72).

10. A method of estimating semiconductor (72) fatigue, the method comprising:
predicting a set of performance characteristics over a period of time based on a predetermined installation location (62) of a semiconductor (72), the set of performance characteristics including at least a predicted semiconductor (72) temperature based on the installation location (62) of the semiconductor (72);
receiving, at a controller module (74), the set of predicted performance characteristics from the semiconductor (72);
generating, by the controller module (74), a semiconductor (72) performance profile from the set of predicted performance characteristics;
comparing, by the controller module (74), the semiconductor (72) performance profile with a fatigue model;
estimating, by the controller module (74), an end of useful life of the semiconductor (72) based on the comparison of the semiconductor (72) profile with the fatigue model; and
scheduling maintenance related to the semiconductor (72) based on the estimated end of useful life of the semiconductor (72).

11. The method of claim 10 wherein the set of performance characteristics includes at least a minimum feature size dimension of the semiconductor (72).

12. The method of claim 11 wherein the fatigue model is selected from a set of fatigue models based on at least the minimum feature size dimension of the semiconductor (72) and the predetermined installation location (62) of the semiconductor (72).

13. The method of any of claims 10 to 12, wherein the fatigue model includes data related to at least a subset of: electromigration fatigue, time-dependent dielectric breakdown, hot carrier injection effects, or bias temperature instability.

14. The method of any of claims 10 to 13, further comprising repeating the predicting, the receiving, the generating, the comparing, and the estimating for each semiconductor (72) in a set of semiconductors (72) of an integrated circuit, selecting the earliest estimated end of useful life of the set of semiconductors, and scheduling maintenance related to the integrated circuit based on the earliest estimated end of useful life of the set of semiconductors (72).
